# FASCICULE DE BREVET EUROPEEN

(11) **EP 3 540 359 B1**
(45) Date de publication et mention de la délivrance du brevet: **05.05.2021**
(21) Numéro de dépôt: 19162672.0
(22) Date de dépôt: 13.03.2019
(51) Int. Cl.: F28F 13/00, H01L 23/367

(54) **DISPOSITIF DE CONDUCTION THERMIQUE ET SYSTÈME DE DISSIPATION DE CHALEUR ASSOCIÉ**
VORRICHTUNG ZUR WÄRMELEITUNG UND ENTSPRECHENDES WÄRMEABLEITUNGSSYSTEM
HEAT CONDUCTION DEVICE AND ASSOCIATED HEAT DISSIPATION SYSTEM

(30) Priorité: 16.03.2018 FR 1852261
(43) Date de publication de la demande: 18.09.2019
(73) Titulaire: ALSTOM Transport Technologies, 93400 Saint-Ouen (FR)
(72) Inventeur: ZANETTI, Adrien, 69100 VILLEURBANNE (FR); BLANCHET, Damien, 01150 BLYES (FR); TUYERAS, Gaetan, 38460 VEYSSILIEU (FR); RAVOT, Julien, 01500 AMBERIEU EN BUGEY (FR)
(74) Mandataire: Lavoix

(56) Documents cités:
- FR-A1- 2 967 763
- US-A1- 2004 188 062
- US-A1- 2007 030 656

## Description

La présente invention concerne un dispositif de conduction thermique destiné à être installé entre une première pièce source de chaleur et une deuxième pièce de dissipation ou de transport de chaleur.

La présente invention concerne également un système de dissipation de chaleur associé.

La source de chaleur est, par exemple, un dispositif électrique ou électronique.

Dans le domaine des systèmes électriques ou électroniques, il est connu d'utiliser des cartes de circuits imprimés portant des composants ayant une forte dissipation de chaleur, ces cartes de circuits imprimés sont généralement montées de manière amovible sur des supports fixes. A l'heure actuelle pour évacuer le flux de chaleur, on monte sur les cartes de circuits imprimés des dissipateurs de chaleur ou radiateurs qui sont associés aux composants à refroidir par conduction thermique et qui sont en général des pièces métalliques à ailettes.

Cependant, de tels radiateurs fixés sur les cartes de circuits imprimés sont souvent lourds, volumineux et doivent être placés au plus près des composants à refroidir, ce qui implique que les systèmes électriques équipés de tels radiateurs sont généralement volumineux et difficiles à implémenter, notamment lorsqu'ils comprennent plusieurs cartes de circuits imprimés disposées parallèlement et associées à un même support.

Un dispositif de conduction thermique est par exemple connu de FR 2 967 763 A.

De plus, il est connu de US 2004/0188062 un dispositif de conduction thermique destiné à être positionné entre une première pièce source de chaleur et une deuxième pièce de dissipation de chaleur. Cependant, la qualité du transfert thermique entre la première pièce source de chaleur et la deuxième pièce de dissipation de chaleur assurée par un tel dispositif de conduction thermique n'est pas optimale. Ainsi, le refroidissement de la première pièce source de chaleur assuré par le dispositif de conduction thermique et la deuxième pièce de dissipation de chaleur est à améliorer. En outre, un tel dispositif est amené à s'user rapidement, notamment lorsque le dispositif est inséré dans un système destiné à subir des vibrations et/ou à être déplacé.

C'est à ces inconvénients qu'entend remédier l'invention en proposant un dispositif de conduction thermique assurant un transfert thermique optimal, c'est-à-dire une conduction thermique optimale entre une pièce source de chaleur et une pièce de dissipation thermique et dont l'usure dans le temps est réduite, tout en permettant avantageusement une installation/désinstallation facilitée du dispositif dans un système de dissipation de chaleur associé.

A cet effet, l'invention a pour objet un dispositif de conduction thermique conforme à la revendication 1.

Grâce à l'utilisation d'éléments mâle et femelle exerçant un effort radial l'un sur l'autre, le contact thermique entre les éléments mâle et femelle est amélioré et donc la conduction thermique assurée par le dispositif de conduction thermique est optimale. En outre, cela permet également d'assurer un verrouillage axial de l'élément mâle par rapport à l'élément femelle et ainsi de limiter toute usure du dispositif liée à un déplacement récurrent de l'élément mâle par rapport à l'élément femelle.

Suivant des modes particuliers de réalisation, l'invention présente l'une ou plusieurs des caractéristiques des revendications 1 à 8.

L'invention a également pour objet un système de dissipation de chaleur conforme à la revendication 9.

L'invention sera mieux comprise et d'autres avantages de celle-ci apparaitront plus clairement à la lumière de la description qui va suivre, donnée uniquement à titre d'exemple non limitatif et faite en se référant aux dessins annexés sur lesquels :
- la figure 1 est une représentation tridimensionnelle partielle d'un système de dissipation de chaleur conforme à l'invention, comprenant un dispositif de conduction thermique positionné entre une première pièce source de chaleur et une deuxième pièce de dissipation de chaleur ;
- la figure 2, est une coupe partielle du système de dissipation de chaleur de la figure 1, suivant le plan II de la figure 1.

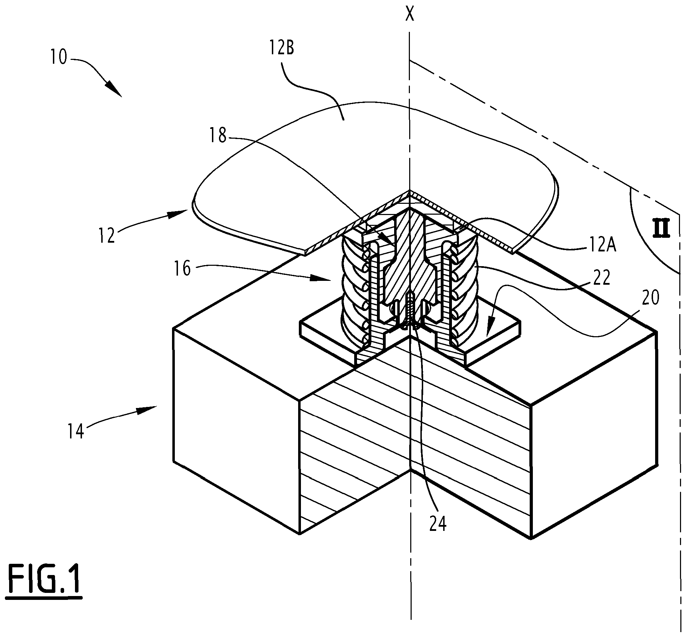

Le système de dissipation de chaleur 10 visible à la figure 1 est avantageusement un système électrique ou électronique et comprend une première pièce 12 source de chaleur et une deuxième pièce 14 de dissipation de chaleur, entre lesquelles est installé un dispositif de conduction thermique 16.

La première pièce 12 est, par exemple, un processeur 12A et notamment une carte de circuits imprimés 12B équipée dudit processeur 12A.

Avantageusement, la carte de circuits imprimés 12B appartient à une antenne de communication, notamment une antenne de communication de données entre un véhicule ferroviaire et un équipement de signalisation ferroviaire. Ladite antenne est destinée à être installée sur le véhicule ferroviaire, par exemple dans une cuve de réception de l'antenne ménagée dans un coffre de traction du véhicule ferroviaire.

En variante, non représentée, la première pièce 12 comprend un élément de collection thermique, tel qu'un caloduc ou tout autre dispositif de transfert de chaleur, relié mécaniquement à une carte de circuits imprimés.

La deuxième pièce 14 est, par exemple, un échangeur de chaleur, tel qu'un dissipateur thermique et notamment tel qu'un radiateur de refroidissement.

Avantageusement, la deuxième pièce 14 est une paroi de la cuve de réception de l'antenne évoquée ci-dessus.

La première pièce 12 et la deuxième pièce 14 ont chacune une position fixe l'une par rapport à l'autre de sorte que lorsque le dispositif de conduction thermique 16 est positionné entre la première pièce 12 et la deuxième pièce 14, il est maintenu en position entre les première et deuxième pièces.

Avantageusement, la position de la première pièce 12 par rapport à la deuxième pièce 14 est réglable.

Dans l'exemple de la figure 1, le système de dissipation de chaleur 10 comprend une seule carte de circuits imprimés 12B et un seul échangeur de chaleur 14.

Cependant, en variante, le système de dissipation de chaleur 10 comprend plusieurs premières pièces 12, par exemple plusieurs cartes de circuits imprimés en parallèle les unes des autres, et pour chaque première pièce un dispositif de conduction thermique 16 associé positionné entre la première pièce et l'échangeur de chaleur 14. Ainsi, dans cette variante, l'échangeur de chaleur est mutualisé pour le refroidissement d'une pluralité de premières pièces 12.

Le dispositif de conduction thermique 16 s'étend suivant un axe longitudinal X et comprend un élément mâle 18 et un élément femelle 20.

Les éléments mâle 18 et femelle 20 sont avantageusement mobiles l'un par rapport à l'autre suivant l'axe longitudinal X, l'élément femelle 20 recevant au moins partiellement l'élément mâle 18.

Le dispositif de conduction thermique 16 comprend un organe de mise en pression 22 propre à exercer sur l'élément mâle et sur l'élément femelle un premier effort d'appui E1, respectivement un deuxième effort d'appui E2, opposés l'un à l'autre. Les premier E1 et deuxième E2 efforts d'appui s'exercent notamment suivant l'axe longitudinal X.

Le dispositif de conduction thermique 16 comprend également un organe de maintien 24 formant une butée de limitation du déplacement axial de l'élément mâle 18 par rapport à l'élément femelle 20 à une valeur maximale prédéterminée.

La valeur maximale prédéterminée est, par exemple, inférieure à 60% de la longueur de l'élément mâle 18 mesurée suivant l'axe longitudinal X.

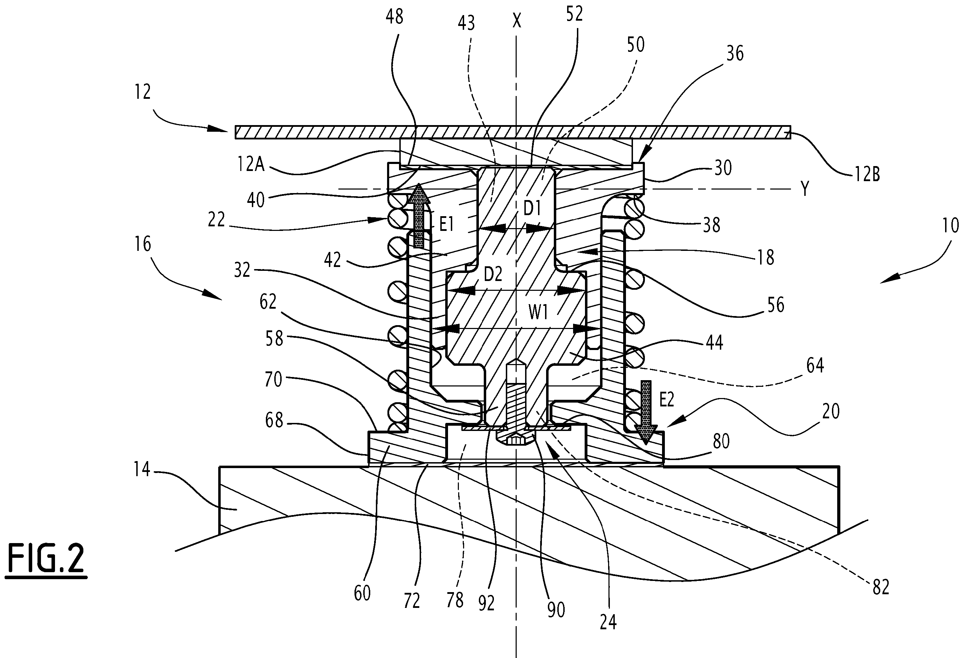

L'élément mâle 18 comprend une base 30 destinée à être en contact thermique avec l'une des première et deuxième pièces, et notamment avec la première pièce 12 dans l'exemple des figures 1 et 2. Dans un mode de réalisation, ce contact sera effectué via une interface thermique de contact.

L'élément mâle 18 comprend également une partie protubérante 32 par rapport à la base 30, s'étendant suivant un premier axe central X1 de l'élément mâle.

En d'autres termes, l'élément mâle comprend successivement suivant le premier axe central X1, la base 30 et la partie protubérante 32.

Avantageusement, et comme représenté sur la figure 2, le premier axe central X1 est confondu avec l'axe longitudinal X. Ainsi, seule la référence X est visible sur la figure 2.

La base 30 comprend, suivant l'axe central X1, une première extrémité de contact 36 avec l'une des première et deuxième pièces, et notamment avec la première pièce 12 dans l'exemple des figures 1 et 2 et une première extrémité d'appui mécanique 38 sur laquelle l'organe de mise en pression 22 est propre à exercer le premier effort d'appui E1.

La première extrémité de contact 36 et la première extrémité d'appui mécanique 38 sont opposées l'une à l'autre suivant le premier axe central X1.

La première extrémité de contact 36 est au moins partiellement recouverte d'une couche 40 de matériau d'interface thermique. Dans un mode de réalisation, cette interface thermique pourrait être une pâte thermique ayant une conductivité thermique comprise entre 0,5 et 11 W/m.K (sans que la valeur supérieure soit limitative suivant le mode de réalisation), à base de silicone ou d'argent. Dans un autre mode de réalisation, cette interface thermique pourrait être une interface de conductivité orthotropique dont la conductivité orthogonale serait la plus élevée possible sans que ce détail soit limitatif ni en terme de performances, ni en terme de composition.

La couche 40 est positionnée en sandwich entre la première extrémité de contact 36 et la première pièce 12 lorsque le dispositif est installé entre la première pièce 12 et la deuxième pièce 14.

La base 30 et la partie protubérante 32 définissent ensemble, suivant un axe transversal Y perpendiculaire au premier axe central X1, une partie circonférentielle 42 et un noyau central 44 de l'élément mâle.

La partie circonférentielle 42 forme un logement 43 de réception du noyau central 44, le logement 43 étant avantageusement traversant suivant l'axe central X1.

Sur la figure 2, la partie circonférentielle 42 est identifiée par des traits en diagonal, orientés de la gauche vers la droite en allant de bas en haut, ayant une première inclinaison par rapport à l'horizontal, et le noyau central 44 par des traits en diagonal, orientés de la gauche vers la droite en allant de bas en haut, ayant une deuxième inclinaison par rapport à l'horizontal supérieure à la première inclinaison.

En d'autres termes, le noyau central 44 est logé dans la partie circonférentielle 42.

Avantageusement, le noyau central 44 est emmanché serré ou fretté dans le logement 43 de réception du noyau.

Le noyau central 44 est avantageusement une pièce pleine.

La partie circonférentielle 42 comprend une face 48 de contact avec l'une des première et deuxième pièces, et notamment avec la première pièce 12 dans l'exemple des figures 1 et 2. La face de contact 48 comprend un orifice central 50 où débouche une première extrémité 52 du noyau central 44, suivant l'axe central X1, destinée à être en contact avec ladite une des première et deuxième pièces, à savoir la première pièce 12 dans l'exemple des figures 1 et 2.

La face de contact 48 et la première extrémité 52 du noyau central forment la première extrémité de contact 36 et sont ainsi, comme expliqué ci-dessus, recouverte au moins partiellement de la couche 40 de matériau d'interface thermique.

Le logement 43 de réception du noyau central comprend, suivant l'axe central X1, en partant de la base 30, une première portion cylindrique ayant un premier diamètre D1 et une deuxième portion cylindrique ayant un deuxième diamètre D2 supérieur au premier diamètre D1.

La première portion cylindrique et la deuxième portion cylindrique sont reliées l'une à l'autre par une paroi transversale 56 formant une butée d'appui du noyau central 44 lorsque le noyau central 44 est assemblé avec la partie circonférentielle 42.

Avantageusement, la valeur du deuxième diamètre D2 est comprise entre 70% et 90% de la valeur de la largeur maximale W1 de la pièce circonférentielle mesurée suivant l'axe transversal Y, au niveau de la deuxième portion cylindrique.

Le noyau central comprend, suivant l'axe central X1, une première partie cylindrique de forme complémentaire de la première portion cylindrique et une deuxième partie cylindrique de forme complémentaire de la deuxième portion cylindrique.

Avantageusement, le noyau central comprend une deuxième extrémité 58 opposée à la première extrémité 52 suivant l'axe X1 et propre à coopérer avec l'organe de maintien 24.

La deuxième extrémité 58 forme avantageusement une troisième partie cylindrique de diamètre inférieur à celui de la deuxième partie cylindrique.

L'élément femelle 20 comprend une semelle 60 destinée à être en contact thermique avec l'autre des première et deuxième pièces, à savoir la deuxième pièce 14 dans l'exemple de la figure 1.

L'élément femelle 20 comprend une paroi interne 62 définissant un logement 64 de réception de la partie protubérante 32 s'étendant suivant un deuxième axe central X2 de l'élément femelle.

Le logement 64 est en saillie par rapport à la semelle 60 suivant l'axe central X2

Avantageusement le deuxième axe central X2 est confondu avec le premier axe central X1 et notamment avec l'axe longitudinal X. Ainsi, seule la référence X est visible sur la figure 2.

L'élément mâle 18 est assemblé avec l'élément femelle 20 de sorte que la partie protubérante 32 est positionnée dans le logement 64 de réception de la partie protubérante.

Avantageusement, une distance radiale entre la partie protubérante 32 et la paroi interne 62 est inférieure ou égale à 5 mm, de préférence à 1 mm, notamment suffisante pour permettre l'assemblage correct de l'élément mâle dans l'élément femelle, pour des températures supérieures à -20°C.

La semelle 60 comprend, suivant l'axe central X2, une deuxième extrémité de contact 68 avec l'une des première et deuxième pièces, et notamment avec la deuxième pièce 14 dans l'exemple des figures 1 et 2, et une deuxième extrémité d'appui mécanique 70 sur laquelle l'organe de mise en pression 22 est propre à exercer le deuxième effort d'appui E2.

La deuxième extrémité de contact 68 et la deuxième extrémité d'appui mécanique 70 sont opposées l'une à l'autre suivant le deuxième axe central X2.

La deuxième extrémité de contact est au moins partiellement recouverte d'une couche 72 de matériau d'interface thermique, tel qu'une pâte thermique ayant une conductivité thermique comprise entre 0,5 et 11 W/m.K, à base de silicone ou d'argent.

Le matériau d'interface thermique est positionné en sandwich entre la deuxième extrémité de contact 68 et la deuxième pièce 14 lorsque le dispositif 16 est installé entre la première pièce 12 et la deuxième pièce 14.

Les éléments mâle 18 et femelle 20 étant avantageusement mobiles l'un par rapport à l'autre, la partie protubérante 32 est propre à être déplacée dans le logement 64 de réception de la partie protubérante suivant les axes centraux X1, X2.

Plus précisément, la partie protubérante 32 est propre à être déplacée dans le logement 64 de réception de la partie protubérante suivant l'axe central du logement via l'application d'un effort de compression entre la base 30 et la semelle 60, de sorte que la distance entre la base et la semelle est propre à être modifiée via l'application de l'effort de compression.

L'application de l'effort de compression permet de facilement installer/désinstaller le dispositif de conduction thermique 16 dans le système de dissipation de chaleur 10.

L'effort de compression est avantageusement supérieur aux premier et deuxième efforts d'appui.

L'élément femelle 20 définit un orifice 78 d'accès depuis l'extérieur du dispositif 16 à l'organe de maintien 24, avantageusement ménagé dans une portion centrale de la semelle 60. L'orifice d'accès 78 traverse la deuxième extrémité de contact 68 suivant l'axe central X2.

Avantageusement, l'élément femelle 20 comprend une paroi radiale interne 80 s'étendant entre l'orifice d'accès 78 et le logement 64 de réception de la partie protubérante.

La paroi radiale interne 80 comprend un orifice 82 reliant l'orifice d'accès 78 au logement 64.

La deuxième extrémité 58 du noyau central est par exemple positionnée dans l'orifice 82 et reçoit l'organe de maintien 24.

Plus précisément, l'organe de maintien 24 comprend une pièce 90 de retenu du noyau central 44 solidaire de la deuxième extrémité 58 du noyau central et une pièce 92 de butée contre la paroi radiale interne 80 positionnée dans l'orifice d'accès 78 et solidaire de la pièce de retenu 90.

La pièce de retenu 90 est par exemple une vis vissée dans la deuxième extrémité 58 du noyau central 44 et la pièce de butée 92 est par exemple une rondelle associée à la vis, c'est-à-dire positionné entre une tête de la vis et une tige filetée de la vis.

L'organe de mise en pression 22 est par exemple un ressort, notamment hélicoïdal, positionné entre la première extrémité d'appui mécanique 38 et la deuxième extrémité d'appui mécanique 70.

Le fonctionnement du dispositif de conduction et les relations d'échange thermique entre les première 12 et deuxième 14 pièces via le dispositif 16 vont désormais être présentées.

La partie protubérante 32 et la paroi interne 62 sont propres à être en relation d'échange thermique, de par notamment la distance les séparant.

L'élément mâle 18 est configuré pour exercer un effort radial contre l'élément femelle 20 et notamment contre la paroi interne 62 lorsque le dispositif de conduction 16 est installé entre la première pièce 12 et la deuxième pièce 14.

Avantageusement, l'élément mâle 18 et l'élément femelle 20 ont des coefficients de dilatation thermique globaux respectifs différents, de sorte que lorsque la température du dispositif de conduction 16 est supérieure à un seuil prédéterminé, la partie protubérante 32 exerce un effort radial contre la paroi interne 62. On entend par coefficient de dilatation thermique global, un coefficient relatif à la dilatation globale d'une pièce.

Un rapport entre les coefficients de dilatation thermique globaux respectifs des éléments mâle 18 et femelle 20 est par exemple et seulement à titre d'exemple compris entre 1,1 et 2, de préférence entre 1,3 et 1,8. En effet les choix de valeurs des coefficients de dilatation thermique restent dépendant des applications.

Une telle caractéristique permet d'améliorer les échanges thermiques entre l'élément mâle et l'élément femelle 20 et ainsi d'assurer une conduction thermique optimisée permettant d'évacuer efficacement le flux de chaleur provenant de la première pièce 12 vers un dissipateur.

Cela permet également d'assurer un verrouillage axial de l'élément mâle 18 par rapport à l'élément femelle 20 et ainsi de limiter toute usure du dispositif, notamment en environnement vibratoire, liée à un déplacement récurrent de l'élément mâle par rapport à l'élément femelle. Un tel déplacement peut notamment intervenir lorsque le système 10 est embarqué sur un véhicule.

En outre la différence de coefficient de dilatation thermique permet, d'une part lorsque la source de chaleur 12 est en fonction et dégage de la chaleur d'assurer le verrouillage axial de l'élément mâle 18 par rapport à l'élément femelle 20, mais également, d'autre part, lorsque la source de chaleur 12 n'est plus en fonction et ne génère plus de chaleur, d'assurer un déverrouillage de la position de l'élément mâle 18 par rapport à l'élément femelle 20 et ainsi de faciliter le retrait du dispositif de conduction thermique 16 du système 10.

Le seuil prédéterminé est déterminé au regard des opérations de maintenance et de la température de fonctionnement du système de dissipation de chaleur.

En variante, le dispositif de conduction thermique 16 comprend un élément de déformation de l'élément mâle propre à déformer l'élément mâle 18, de sorte à générer l'effort radial. L'élément de déformation comprend par exemple une vis propre à être vissée dans le noyau central 44 et à le déformer ou un élément de mise en pression propre à exercer un effort de pression sur l'élément mâle 18 afin de le déformer suivant une direction radiale.

Avantageusement, le noyau central 44 et la partie circonférentielle 42 ont des coefficients de dilatation thermique respectifs différents, de sorte que lorsque la température du dispositif de conduction 16 est supérieure au seuil prédéterminé, le noyau central 44 exerce une force radiale contre la partie circonférentielle 42, qui est alors propre, de par sa déformation liée à la force radiale, à exercer une force radiale contre l'élément femelle 20 et notamment la paroi interne 62.

Selon une autre variante, un premier élément, choisi parmi la partie circonférentielle 42 et le noyau central 44, a un coefficient de dilatation thermique supérieur au coefficient de dilatation thermique de l'élément femelle 20, de sorte que lorsque la température du dispositif de conduction 16 est supérieure au seuil prédéterminé, la partie protubérante 32 et notamment la partie circonférentielle 42 exerce l'effort radial contre la paroi interne 62.

La conductivité thermique du noyau central 44 est, de préférence, supérieure à la conductivité thermique de la partie circonférentielle 42, et le noyau central 44 a un coefficient de dilatation thermique supérieur au coefficient de dilatation thermique de la partie circonférentielle 42.

Avantageusement, la partie circonférentielle 42 et l'élément femelle 20 ont des coefficients de dilatation thermique respectifs sensiblement identiques.

Le noyau central 44 et la partie circonférentielle 42 sont dans un matériau différent choisi par exemple parmi la liste suivante : cuivre, bronze, aluminium, zamak ou tout autre alliage de tels matériaux.

Lorsque le dispositif 16 est installé entre la première pièce 12 et la deuxième pièce 14, l'organe de mise en pression 22 est comprimé et exerce le premier effort d'appui sur la base et le deuxième effort d'appui sur la semelle. Cela permet de maintenir en position le dispositif par rapport aux première et deuxième pièces et d'assurer un contact thermique et donc des échanges thermiques optimaux entre, d'une part la base 30 et la première pièce 12 et, d'autre part, la semelle 60 et la deuxième pièce 14.

En outre le fait que les éléments mâle et femelle soient mobiles l'un par rapport à l'autre permet d'adapter la longueur du dispositif de conduction 16 à l'espace entre les première 12 et deuxième 14 pièces.

Les modes de réalisation et variantes envisagés ci-dessus sont propre à être combinés entre eux pour donner lieu à d'autres modes de réalisation de l'invention.

## Revendications

1. Dispositif (16) de conduction thermique destiné à être installé entre une première pièce (12) source de chaleur et une deuxième pièce (14) de dissipation de chaleur, le dispositif de conduction thermique comprenant :
- un élément mâle (18) comprenant une base (30) destinée à être en contact thermique avec l'une des première et deuxième pièces,
- un élément femelle (20) comprenant une semelle (60) destinée à être en contact thermique avec l'autre des première et deuxième pièces,
l'élément mâle (18) comprenant une partie protubérante (32) par rapport à la base (30) et l'élément femelle (20) comprenant une paroi interne (62) définissant un logement (64) de réception de la partie protubérante (32), la partie protubérante (32) et la paroi interne (62) étant propres à être en relation d'échange thermique, l'élément mâle (18) étant configuré pour exercer un effort radial contre la paroi interne (62) lorsque le dispositif de conduction thermique est installé entre la première pièce (12) et la deuxième pièce (14) de sorte à améliorer la conduction thermique entre l'élément mâle (18) et l'élément femelle (20),
**caractérisé en ce que** l'élément mâle (18) et l'élément femelle (20) ont des coefficients de dilatation thermique globaux respectifs différents, de sorte que lorsque la température du dispositif de conduction (16) est supérieure à un seuil prédéterminé, la partie protubérante (32) exerce l'effort radial contre la paroi interne (62).

2. Dispositif de conduction thermique selon la revendication 1, dans lequel la partie protubérante (32) est propre à être déplacée dans le logement (64) de réception de la partie protubérante, suivant un axe central du logement, via l'application d'un effort de compression entre la base (30) et la semelle (60), de sorte que la distance entre la base (30) et la semelle (60) est propre à être modifiée via l'application de l'effort de compression.

3. Dispositif de conduction thermique selon la revendication 1 ou 2, dans lequel la partie protubérante (32) est propre à être déplacée dans le logement (64) de réception de la partie protubérante suivant un axe central du logement, et dans lequel le dispositif de conduction thermique (16) comprend un organe de mise en pression (22) propre à exercer sur l'élément mâle (18) et sur l'élément femelle (20) un premier effort d'appui (E1), respectivement un deuxième effort d'appui (E2) opposés l'un à l'autre.

4. Dispositif de conduction thermique selon la revendication 3, dans lequel l'organe de mise en pression (22) est un ressort s'étendant entre la base (30) et la semelle (60) suivant l'axe central.

5. Dispositif de conduction thermique selon la revendication 3 ou 4, dans lequel le dispositif comprend un organe de maintien (24) formant une butée de limitation du déplacement axial de l'élément mâle (18) par rapport à l'élément femelle (20) à une valeur maximale prédéterminée.

6. Dispositif de conduction thermique selon l'une quelconque des revendications précédentes, dans lequel la base (30) et la partie protubérante (32) définissent ensemble une partie circonférentielle (42) et un noyau central (44) de l'élément mâle, la partie circonférentielle (42) formant un logement de réception du noyau central (44), le noyau central et la partie circonférentielle ayant des coefficients de dilatation thermique respectifs différents, de sorte que lorsque la température du dispositif de conduction est supérieure à un seuil prédéterminé, le noyau central (44) exerce une force radiale contre la partie circonférentielle (42).

7. Dispositif de conduction thermique selon la revendication 6, dans lequel la partie circonférentielle (42) comprend une face (48) de contact avec l'une des première (12) et deuxième (14) pièces, la face de contact (48) comprenant un orifice central (50) où débouche une première extrémité du noyau central (44) destinée à être en contact avec ladite une des première et deuxième pièces.

8. Dispositif de conduction thermique selon la revendication 6 ou 7, dans lequel un premier élément, choisi parmi la partie circonférentielle (42) et le noyau central (44), a un coefficient de dilatation thermique supérieur au coefficient de dilatation thermique de l'élément femelle (20), de sorte que lorsque la température du dispositif de conduction est supérieure à un seuil prédéterminé, la partie protubérante (32) exerce l'effort radial contre la paroi interne (62).

9. Système de dissipation de chaleur comprenant une première pièce (12) source de chaleur et une deuxième (14) pièce de dissipation de chaleur, le système comprenant un dispositif de conduction thermique (16) installé entre la première pièce et la deuxième pièce, **caractérisé en ce que** le dispositif de conduction thermique est selon l'une quelconque des revendications précédentes.

## Patentansprüche

1. Wärmeleitvorrichtung (16), die vorgesehen ist, zwischen einem ersten Wärmequellenteil (12) und einem Wärmeabgabeteil (14) installiert zu sein, wobei die Wärmeleitvorrichtung umfasst:
- ein Einsteckelement (18), das einen Sockel (30) umfasst, der vorgesehen ist, im Wärmekontakt mit einem des ersten und zweiten Teils zu sein,
- ein Aufnahmeelement (20), das einen Flansch (60) umfasst, der vorgesehen ist, im Wärmekontakt mit dem anderen des ersten und zweiten Teils zu sein,
wobei das Einsteckelement (18) ein in Bezug auf den Sockel (30) herausragendes Teil (32) umfasst und das Aufnahmeelement (20) eine Innenwand (32) umfasst, die einen Aufnahmeraum (64) für das herausragende Teil (32) begrenzt, wobei das herausragende Teil (32) und die Innenwand (62) geeignet sind, in einer Wärmeaustauschbeziehung zu sein, wobei das Einsteckelement (18) ausgebildet ist, eine radiale Kraft gegen die Innenwand (62) auszuüben, wenn die Wärmeleitvorrichtung zwischen dem ersten Teil (12) und dem zweiten Teil (14) installiert ist, um die Wärmeleitfähigkeit zwischen dem Einsteckelement (18) und dem Aufnahmeelement (20) zu verbessern,
**dadurch gekennzeichnet, dass** das Einsteckelement (18) und das Aufnahmeelement (20) jeweils unterschiedliche globale Wärmeausdehnungskoeffizienten aufweisen, derart dass, wenn die Temperatur der Wärmeleitvorrichtung (16) höher ist als eine vorbestimmte Schwelle, das herausragende Teil (32) die radiale Kraft gegen die Innenwand (62) ausübt.

2. Wärmeleitvorrichtung nach Anspruch 1, bei der das herausragende Teil (32) geeignet ist, in dem Aufnahmeraum (64) des herausragenden Teils gemäß einer Mittelachse des Aufnahmeraum über die Anwendung einer Kompressionskraft zwischen dem Sockel (30) und dem Flansch (60) verschoben zu werden, derart dass der Abstand zwischen dem Sockel (30) und dem Flansch (60) über die Anwendung der Kompressionskraft modifiziert werden kann.

3. Wärmeleitvorrichtung nach Anspruch 1 oder 2, bei dem das herausragende Teil (32) geeignet ist, in dem Aufnahmeraum (64) des herausragenden Teils gemäß einer Mittelachse des Aufnahmeraums bewegt zu werden, und wobei die Wärmeleitvorrichtung (16) ein Druckerzeugungselement (22) umfasst, das geeignet ist, auf das Einsteckelement (18) und das Aufnahmeelement (20) eine erste Druckkraft (E1), respektive eine zweite Druckkraft (E2), die einander entgegengesetzt sind, auszuüben.

4. Wärmeleitvorrichtung nach Anspruch 3, bei der das Druckerzeugungselement (22) eine Feder ist, die sich zwischen dem Sockel (30) und dem Flansch (60) gemäß der Mittelachse erstreckt.

5. Wärmeleitvorrichtung nach Anspruch 3 oder 4, bei der die Vorrichtung ein Halteelement (24) umfasst, das einen Anschlag zur Begrenzung der axialen Bewegung des Einsteckelementes (18) in Bezug auf das Aufnahmeelement (20) bei einem vorbestimmten Maximalwert bildet.

6. Wärmeleitvorrichtung nach einem beliebigen der vorhergehenden Ansprüche, bei der der Sockel (30) und das herausragende Teil (32) zusammen einen Umfangsbereich (42) und einen Mittelkern (44) des Einsteckelementes definieren, wobei der Umfangsbereich (42) einen Aufnahmeraum für den Mittelkern (44) bildet und der Mittelkern und der Umfangsbereich jeweils unterschiedliche Wärmeausdehnungskoeffizienten aufweisen, derart dass, wenn die Temperatur der Wärmeleitvorrichtung höher als eine vorbestimmte Schwelle ist, der Mittelkern (44) eine radiale Kraft gegen den Umfangsbereich (42) ausübt.

7. Wärmeleitvorrichtung nach Anspruch 6, bei dem der Umfangsbereich (42) eine Kontaktfläche (48) mit einem des ersten (12) und zweiten (14) Teils umfasst, wobei die Kontaktfläche (48) eine Mittelöffnung (50) aufweist, an der ein erstes Ende des Mittelkerns (44) mündet, das vorgesehen ist, in Kontakt mit dem einen des ersten und zweiten Teils zu sein.

8. Wärmeleitvorrichtung nach Anspruch 6 oder 7, bei dem ein erstes Element, ausgewählt aus dem Umfangsbereich (42) und dem Mittelkern (44), einen Wärmeausdehnungskoeffizienten aufweist, der größer ist als der Wärmeausdehnungskoeffizienten des Aufnahmeelementes (20), derart dass, wenn die Temperatur der Wärmeleitvorrichtung höher als eine vorbestimmte Schwelle ist, das herausragende Teil (32) die radiale Kraft gegen die Innenwand (62) ausübt.

9. Wärmeabgabesystem, das ein erstes Wärmequellenteil (12) und ein zweites Wärmeabgabeteil (14) umfasst, wobei das System eine Wärmeleitvorrichtung (16) umfasst, die zwischen dem ersten Teil und dem zweiten Teil installiert ist, **dadurch gekennzeichnet, dass** die Wärmeleitvorrichtung nach einem beliebigen der vorhergehenden Ansprüche ausgebildet ist.

## Claims

1. A thermal conduction device (16) intended to be installed between a first heat source part (12) and a second heat dissipation part (14), the thermal conduction device comprising:
- a male element (18) comprising a base (30) intended to be in thermal contact with one of the first and second parts,
- a female element (20) comprising a base plate (60) intended to be in thermal contact with the other of the first and second parts,
the male element (18) comprising a protruding part (32) relative to the base (30) and the female element (20) comprising an inner wall (62) defining a housing (64) for receiving the protruding part (32), the protruding part (32) and the inner wall (62) being able to be in a thermal exchange relationship, the male element (18) being configured to exert a radial force against the inner wall (62) when the thermal conduction device is installed between the first part (12) and the second part (14) so as to improve the thermal conduction between the male element (18) and the female element (20),
**characterized in that**, the male element (18) and the female element (20) have different respective overall thermal expansion coefficients, such that when the temperature of the conduction device (16) is above a predetermined threshold, the protruding part (32) exerts the radial force against the inner wall (62).

2. The thermal conduction device according to claim 1, wherein the protruding part (32) is able to be moved in the receiving housing (64) of the protruding part, along a central axis of the housing, by applying a compression force between the base (30) and the base plate (60), such that the distance between the base (30) and the base plate (60) is able to be modified by applying the compression force.

3. The thermal conduction device according to claim 1 or 2, wherein the protruding part (32) is able to be moved in the receiving housing (64) of the protruding part along a central axis of the housing, and wherein the thermal conduction device (16) comprises a pressing member (22) able to exert a first bearing force (E1), respectively a second bearing force (E2) opposite one another, on the male element (18) and on the female element (20).

4. The thermal conduction device according to claim 3, wherein the pressing member (22) is a spring extending between the base (30) and the base plate (60) along the central axis.

5. The thermal conduction device according to claim 3 or 4, wherein the device comprises a maintaining member (24) forming a stop limiting the axial movement of the male element (18) relative to the female element (20) to a predetermined maximum value.

6. The thermal conduction device according to any one of the preceding claims, wherein the base (30) and the protruding part (32) together define a circumferential part (42) and a central core (44) of the male element, the circumferential part (42) forming a receiving housing of the central core (44), the central core and the circumferential part having different respective thermal expansion coefficients, such that when the temperature of the conduction device is above a predetermined threshold, the central core (44) exerts a radial force against the circumferential part (42).

7. The thermal conduction device according to claim 6, wherein the circumferential part (42) comprises a contact face (48) with one of the first (12) and second (14) parts, the contact face (48) comprising a central orifice (50) where a first end of the central core (44) emerges intended to be in contact with said one of the first and second parts.

8. The thermal conduction device according to claim 6 or 7, wherein a first element, chosen from among the circumferential part (42) and the central core (44), has a thermal expansion coefficient greater than the thermal expansion coefficient of the female element (20), such that when the temperature of the conduction device is above a predetermined threshold, the protruding part (32) exerts the radial force against the inner wall (62).

9. A heat dissipation system comprising a first heat source part (12) and a second heat dissipation part (14), the system comprising a thermal conduction device (16) installed between the first part and the second part, **characterized in that** the thermal conduction device is according to any one of the preceding claims.
